# EUROPEAN PATENT APPLICATION

(11) **EP 1 598 874 A1**
(43) Date of publication of application: **23.11.2005**
(21) Application number: 04076495.3
(22) Date of filing: 19.05.2004
(51) Int. Cl.: H01L 31/042, H01L 31/05

(54) **Solar cell assembly**

(71) Applicant: Dutch Space B.V., 2333 CP Leiden (NL)
(72) Inventor: Zwanenburg, Robert, 2403 XD Alphen Aan den Rijn (NL)
(74) Representative: van Westenbrugge, Andries

(57) **Abstract**

A solar cell assembly comprises a plurality of film solar cells which are arranged in a row, in which row the front edge of a preceding solar cell overlaps the back edge of an adjacent subsequent solar cell and the overlapping corners of said overlapping edges are connected to each other. Each overlapping corner of a solar cell has at least one aperture, each aperture of a solar cell being in register with an aperture of the adjacent solar cell and said registered apertures each accommodating a connection element.

## Description

The invention is related to a solar cell assembly comprising a plurality of film solar cells which are arranged in a row, in which row the front edge of a preceding solar cell overlaps the back edge of an adjacent subsequent solar cell and the overlapping corners of said overlapping edges are connected to each other.

A solar cell assembly of this type is disclosed in US-A-4617421. This prior art assembly comprises thin film solar cells which are connected to each other through tack welds at the overlapping edges. The thin film solar cells comprise multiple thin layers, one of which can be a metal foil. The electrical interconnection between these solar cells is obtained by means of interposed electrically conducting strips.

An important feature of said solar cell assembly is its low mass. Such assembly is therefore lightweight and in particular suitable for use as a solar array for a spacecraft. Said prior art assembly however has the disadvantage that the electrical and mechanical connection of the solar cells to each other is direct and therefore not flexible. As a result, the fragile solar cells would be exposed to high mechanical loads at the connections due to the extreme cold and hot conditions which occur in space. In this connection, the mismatch in the thermal expansion ratio of the various materials which make up the assembly plays a significant role. Consequently, an additional supporting layer will be necessary so as to avoid rupture of the solar cells.

The object of the invention is to provide an assembly of the type described before which does not have this problem and which is therefore less vulnerable to extreme environmental conditions and which is self supporting. This object is achieved in that at least one electrically isolating connection element is provided which protrudes through two overlapping corners.

A first advantage of the assembly according to the invention is that the process of assembling the solar cells is simplified. The solar cells do not need to be bonded to a supporting structure having regard to the fact that the solar cells themselves form a mechanical structure which is able to carry shear loads whereby mass and manufacturing costs are saved. A further advantage is that the connections between the solar cells allow a certain adaptability to varying loads.

Preferably, each overlapping corner of a solar cell has at least one aperture, each aperture of a solar cell being in register with an aperture of the adjacent solar cell and said registered apertures each accommodating a connection element.

The connection elements can be carried out in several ways; in a preferred embodiment the connection elements each comprise at least one pin which protrudes through a pair of registered apertures, said pin having at one end a head, as well as a closure fitted on the pin, between which head and closure the corners of the solar cells are enclosed. More preferably, the connection elements may each comprise two pins which are connected through a common head.

The closures may comprise a closure strip having two pairs of holes into which the pins are connected; the pins can be connected to the closure strip through a snap fit.

According to a further important feature of the invention, the closures may have a resilient character, e.g. a wave form. The advantage of such resilient closure lies in its ability to provide flexibility at the connection points, whereby the effects of internal loads as a result of temperature fluctuations are mitigated. Also, a well defined contact pressure can thereby be maintained between the solar cells.

The overlapping edges of adjacent solar cells provide an electrical connection, which may be improved by providing an electrically conducting strip between each pair of overlapping edges. The connecting elements protrude through the electrically conducting strips. Additionally, the electrically conducting strips may provide resiliency in the direction perpendicular with respect to the facing sides of the overlapping edges. For instance, the electrically conducting strip may have a wave form, or the electrically conducting strip at its opposite ends may have end parts which are folded back. The connection elements may protrude through both the electrically conducting strip and the folded back parts.

The invention is furthermore related to a blanket comprising a plurality of solar cell assemblies as described before, said assemblies each comprising a plurality of film solar cells which are arranged in a row, in which row the front edge of a preceding solar cell overlaps the back edge of an adjacent subsequent solar cell and the overlapping corners of said overlapping edges are connected to each other, the rows of solar cells of said assemblies being positioned next to each other in such a way that the longitudinal sides of two neighbouring rows face each other. According to a further aspect of the invention at least one connection element at a corner of a cell in one of the rows is connected to a neighbouring connection element at a corner of a cell in a neighbouring row. Preferably all neighbouring cell corners of said rows are connected in a similar fashion. In this way, a blanket with a multitude of interconnected rows can be obtained.

The connection strip of one blanket can be connected to a connection strip of another blanket in several ways. For instance, the connection can be carried out as a pin connection, e.g. a bolt connection. Alternatively, the connection can be carried out as a hinge connection.

In the latter case, the blankets can be stowed in a limited space and be deployed to a large solar array. With the aim of ensuring a proper support of the several blankets which are folded over onto each other, they can be mutually supported with respect to each other. This can be achieved by providing in one blanket a connection strip, which is positioned between four neighbouring corners, with a cushion element for abutting against a correspondingly positioned cushion element of the other blanket when said blankets are folded over onto each other.

The mutual support can be further improved in case a connection strip of one of the blankets has serrations which engage similar serrations on the connection strip of the other blanket when said blankets are folded over onto each other, for preventing relative motions of said blankets parallel to each other. Said serrations may extend in the lengthwise direction of the rows and/or in the breadthwise direction of the rows. Preferably, the connection strip has two opposite cushion elements which face away from each other so as two provide support with respect to both neighbouring blankets.

The invention will now be described further with reference to the embodiments shown in the drawings, entitled:
- Fig. 1: Thin film solar cell
- Fig. 2: Solar cell blanket consisting of solar cells and connection strips
- Fig. 3: Detail of connection between solar cells
- Fig. 4: Detail of connection with a elastic clip system
- Fig. 5: Solar cells with conduction strip in exploded view
- Fig. 6a-d: Conduction strip with spring action
- Fig. 7: Parallel connection between solar cell rows
- Fig. 8: Solar cell series connection between solar cell rows
- Fig. 9: Blanket with wiring connection to string end
- Fig. 10: Enlarged detail of string ending in the middle of the solar cell blanket of figure 9
- Fig. 11: Additional sheet at string end location
- Fig. 12: Fixation of electrical wiring
- Fig. 13: Detail of electrical wiring fixation
- Fig. 14: Fixation of solar cell blanket edge to frame
- Fig. 15: Connection between solar cell blanket parts in length direction
- Fig. 16: Connection between solar cell blanket parts in width direction
- Fig. 17A, B: Hinge type versions of the connection strip
- Fig. 18: Typical fold out solar cell blanket
- Fig. 19: Joint between two connection strips
- Fig. 20: Routing of series connected solar cells
- Fig. 21A, B: Solar cell blanket fold line using a connection strip with elastic hinge
- Fig. 22: Connection strip with cushion elements
- Fig. 23: Stack of solar cell blanket layers between two pressure plates
- Fig. 24: In-plane shear type connection strip
- Fig. 25: Alternative in-plane shear type connection strip
- Fig. 26: Detail of the solar cell blanket assembly
- Fig. 27: Detail of the blanket stacking at the in-plane shear connection

Figure I shows the basic parts of a thin film solar cell 1. The solar cell consists of a solar cell layer 2 deposited on a conductive foil 3, preferably stainless steel or titanium. The said conductive foil 3 is electrically connected to one side of the solar cell layer 2. The other electrical side of said solar cell layer 2 is formed by the conductive grid fingers pattern 4 comprising fingers 36 and bus bar 37, in conjunction with a transparent conductive coating 5 on the front side of the solar cell. The front side of the solar cell is taken with the (-) polarity and the rear side of the solar cell is taken with the (+) polarity. Protective coatings (not shown for clarity) are applied on the front and rear side of the solar cell. The various layers are shown for clarity with exaggerated thickness. In reality the layers are very thin.

According to the invention, apertures 6 are made in the cell corners for mechanical connection purposes. There is a preference to make at least two apertures 6 in each of the cell corners to enable the transfer of forces and moments to adjacent cells through the said apertures 6. The apertures 6 extend through the conductive foil and the solar cell layer 2, but not through the grid fingers pattern 4, nor through the transparent conductive coatings.

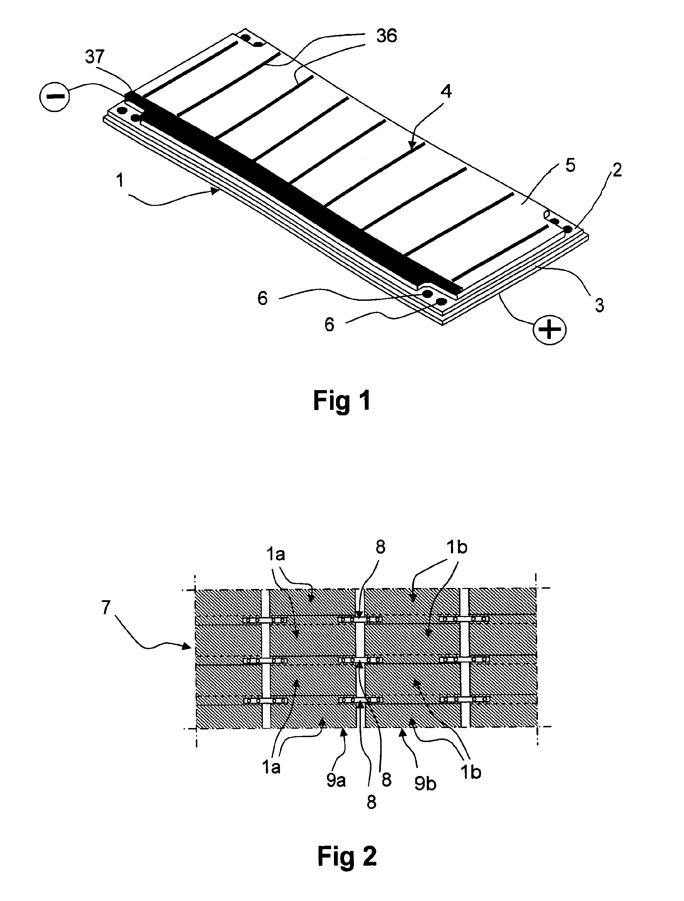

Figure 2 shows an embodiment of the invention where a solar cell blanket 7 is formed by joining the thin film solar cells 1a resp. 1b with connection strips 8. Each connection strip 8 joins generally the corners of four adjacent solar cells. The connections strips 8 connect the solar cells 1a in rows 9a and the solar cells 1b in row 9b and at the same time connects these rows 9a and 9b in a parallel fashion together. In a similar manner more solar cells are connected to enlarge the size of the solar cell blanket. The connection strips 8 are made of non conductive material. The said connection strips 8 are preferably fitted to the solar cell rear side (as shown in figure 2), but other design solutions are possible with the said connection strips 8 on the solar cell front side or as well on the front side and rear side.

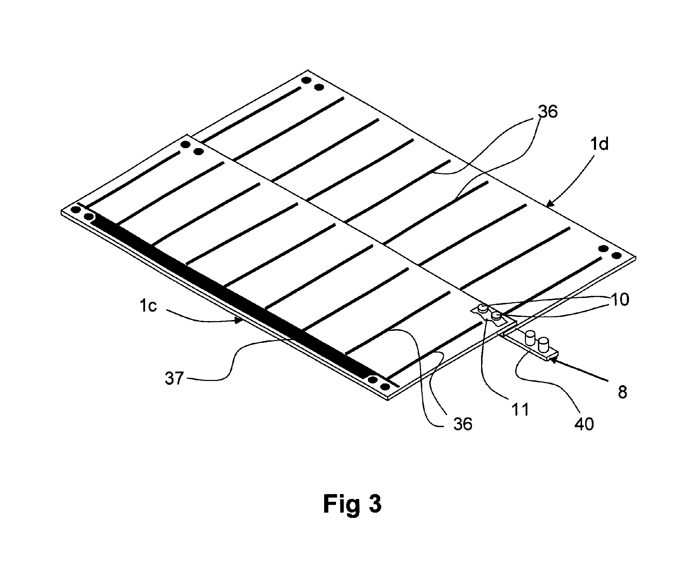

Figure 3 shows a detail of the joining of two solar cells 1c and 1d. The connection is made in an overlap fashion such that the rear side of the solar cell 1c contacts electrically with the front side of the adjacent solar cell 1d creating in this way a series connection that increases the voltage output of the assembly of electrical connected solar cells. The solar cells 1c and 1d are mechanically joint together by two connection elements 10 which are carried out as pins with head 40, forming part of the non conductive connection strip 8. Said connection strip comprises two further connection elements 10, for mutually connection similar solar cells in an adjacent row as mentioned before.

A good conductive surface and a certain minimum contact pressure are needed to obtain a good electrical contact between the joined solar cells. The preferred solution for space applications is a contact surface coating of gold, but several alternative coatings can also work properly. The contact pressure can be obtained by a proper design and material choice of the connection elements 10. A closure 11 carried out as a curved plate acting as a spring can be added to ensure a certain amount of pre-load on the connecting surfaces between the solar cells.

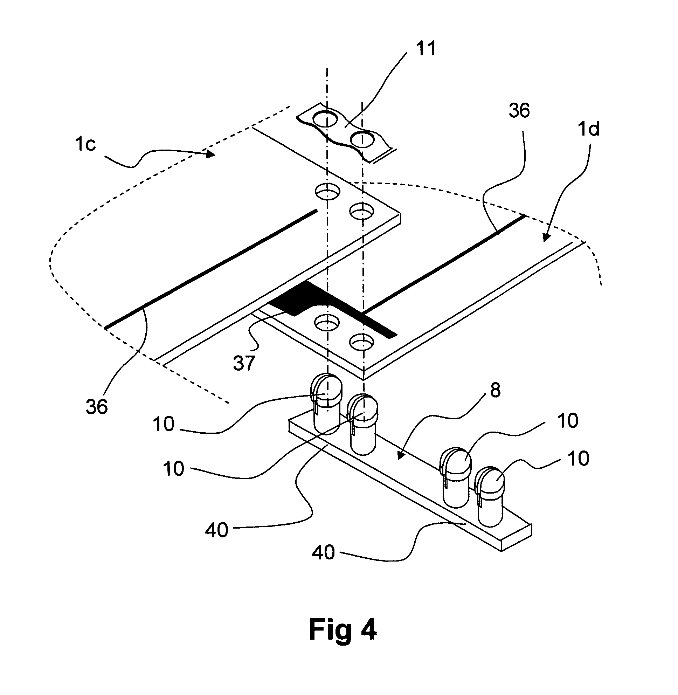

Figure 4 shows an exploded view of the detail assembly of the said two solar cell 1c and 1d with the connection strip 8 and spring plate 11. The connection elements 10 as part of the connection strip 8 are shown as an elastic push clips. This is only one example of the various methods that can be used for the mechanical joining of the solar cells by the connection strips 8.

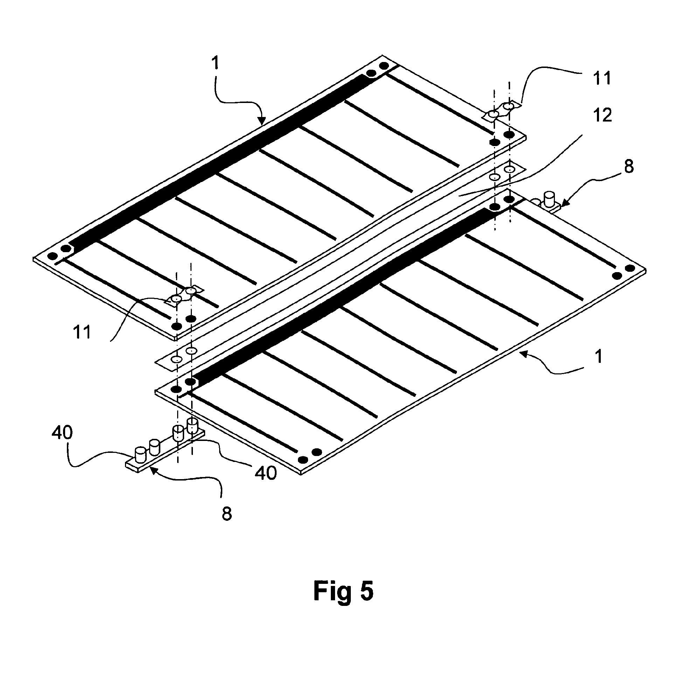

Figure 5 shows an exploded view of the cell to cell joining with another embodiment of the invention, where a conduction strip 12 is added in-between the solar cells 1. The said conduction strips 12 can be used to improve the electrical contact between adjacent solar cells. The conduction strip 12 is shown here as a flat plate element, but the said conduction strips 12 can have various shapes to act as a spring element between the adjacent solar cells 1 to maintain a certain contact pressure. If the spring function is transferred to the conduction strips 12 then the separate spring elements 11 can be omitted. The conduction strip 12 is drawn as a single strip but could be split in two parts concentrating the material only at the connections area at the apertures. The conduction strip would then look like the spring plate 11, but fitted between the adjacent solar cells.

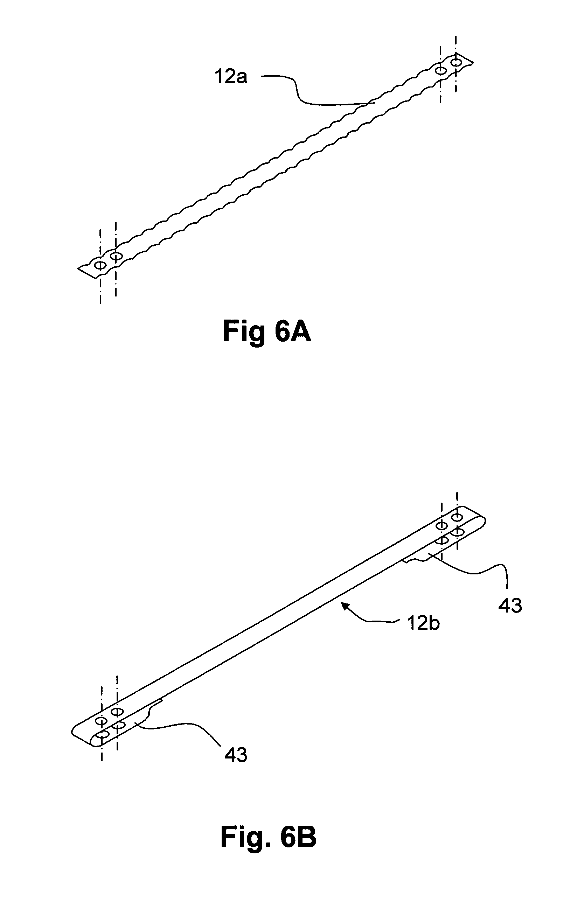

Figures 6a-d show some examples of different shapes of the conduction strip. Figure 6a shows the conduction strips 12a in a wavy shape so that it acts as a spring element between the two clamped solar cells to ensure a minimum contact pressure on the electrical contacts. Figure 6b shows the conduction strip 12b in a bend shape with bended parts 43 as another means to implement a spring function in the said conduction strip. These are just two examples of the possible variation in shapes of the said conduction strip and other variations or combinations can be applied here.

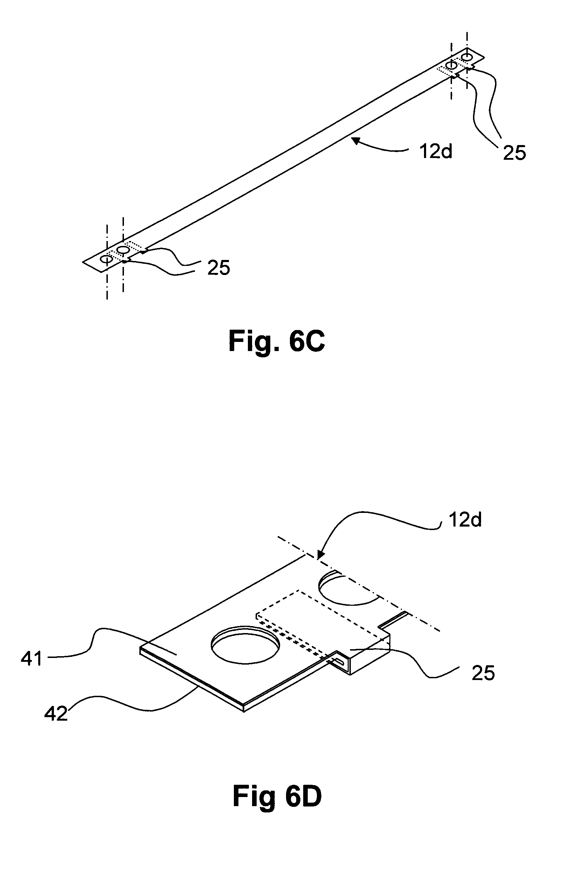

Figure 6c and figure 6d show a conduction strip that consists of a conductive layer 41 and an isolation layer 42. The conduction strip is provided with lips 25 that are folded along the edge of the conduction strip 12f, such that a small conductive surface is created on the rear side of the conduction strip 12f. The isolation layer 42 of conduction strip 12f electrically isolates the conductive layer 3 of each of the solar cells from each other in the joined area. The conductive layer 41 of the front side of the conduction strip 12f is in electrical contact with the rear side of conductive layer 3 of one of the joined solar cells 1, while the small lips 25 contact at dedicated positions the grid structure 4 on the front side of the other solar cell.

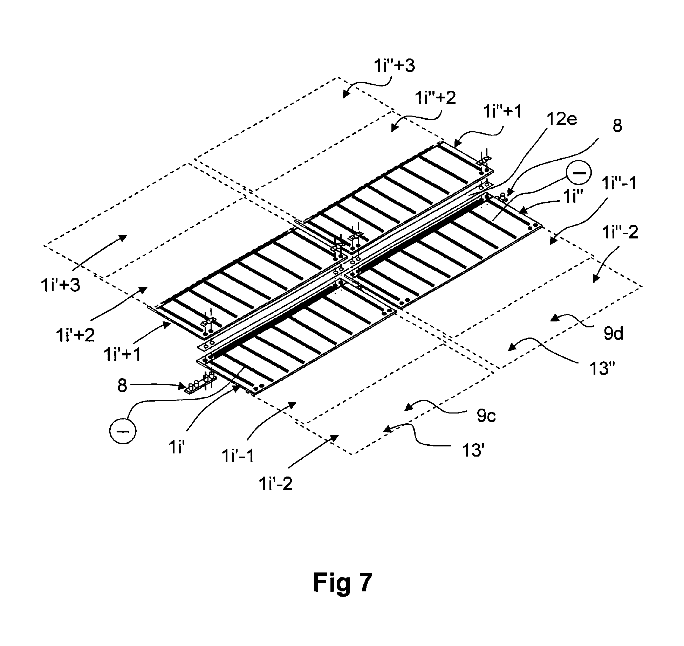

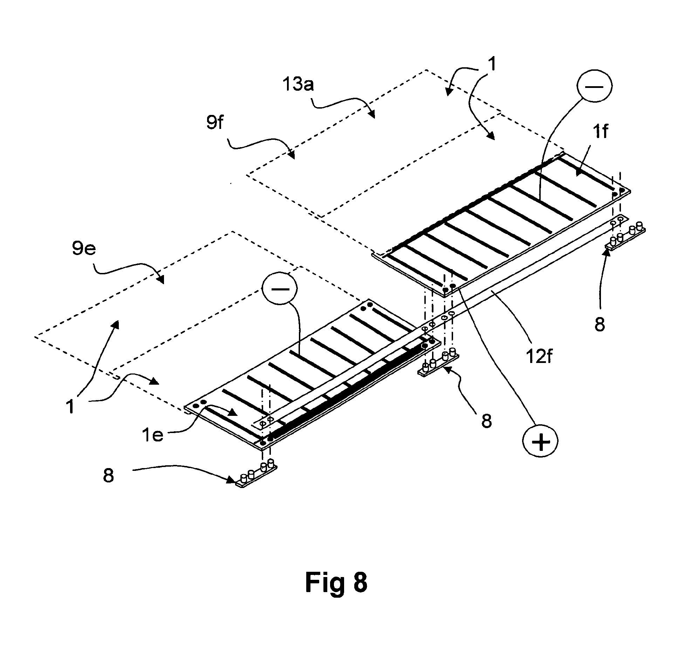

Figure 7 and Figure 8 show another embodiment of the invention at which a parallel electrical connection is made between the solar cells of adjacent rows by enlarging the size of the conduction strip 12 and to use the conduction strip over more than one solar cell row. Figure 7 shows a detail of two solar cells rows 9c and 9d that are connected electrically in parallel by an extended conduction strip 12e. The row of solar cells 9c forms part of solar cell string 13' and row of solar cells 9d forms part of the solar cell string 13".

Each solar cell string 13 consists of a number [n] of series connected solar cells. A proper electrical parallel connection between the solar cell strings can only be made by connecting the solar cell strings at the same solar cell number of the string. In figure 7 this is shown at solar cell 1i' of string 13' and solar cell number 1i" of string 13", at which the annotation [i] stand for the particular position in each of the said solar cell strings and where [i] is running from [1] at the start of the strings until [n] at the end of the string. This parallel connection can be made at any solar cell position [i] of the string or at selected positions only.

Figure 8 shows a detail of two rows of solar cells 9e and 9f that are electrically connected in series by the elongated conduction strip 12f. The two rows of the solar cell are forming part of the same solar cell string 13a. In this case the (-) of solar cell 1e of row 9e is connected to the (+) side of the solar cell 1f in the adjacent row 9f. This way of series connection is in generally performed at the edge of the solar cell blanket or at a solar cell blanket split.

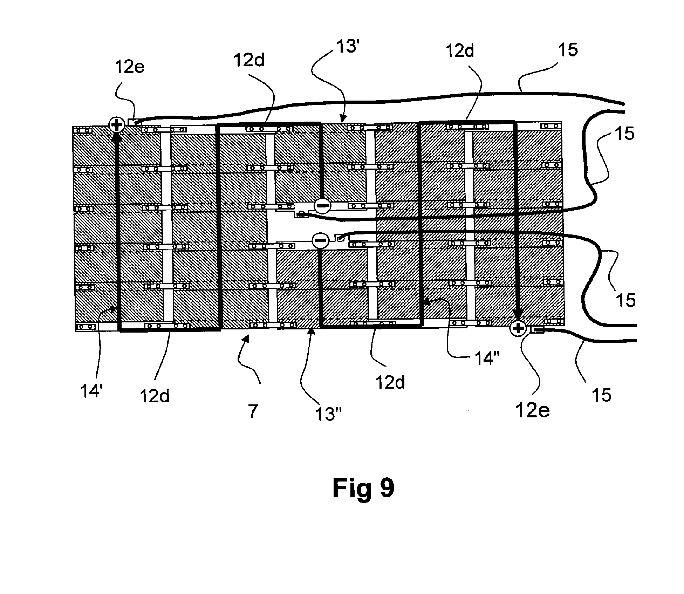

Figure 9 shows a layout of a solar cell blanket assembly 7 consisting of two solar cell strings 13' and 13". Each solar cell string consists of 12 series connected solar cells 1. The arrows 14' and 14" represent the series connection line of the corresponding solar cell string 13' and 13". Figure 9 shows only a small part of a blanket layout. The actual solar cell blanket is in general much larger. The solar cells strings may consist of more than 80 solar cells connected in series to supply the electrical power at the required interface voltage. The power generated by the solar cell blanket 7 has to be transferred to a spacecraft power system by means of a set of transfer wires 15 that are connected to the solar cell string ends. The said wiring is connected electrically and mechanically to modified conductive strips 12e at the first and last solar cell of the solar cell strings

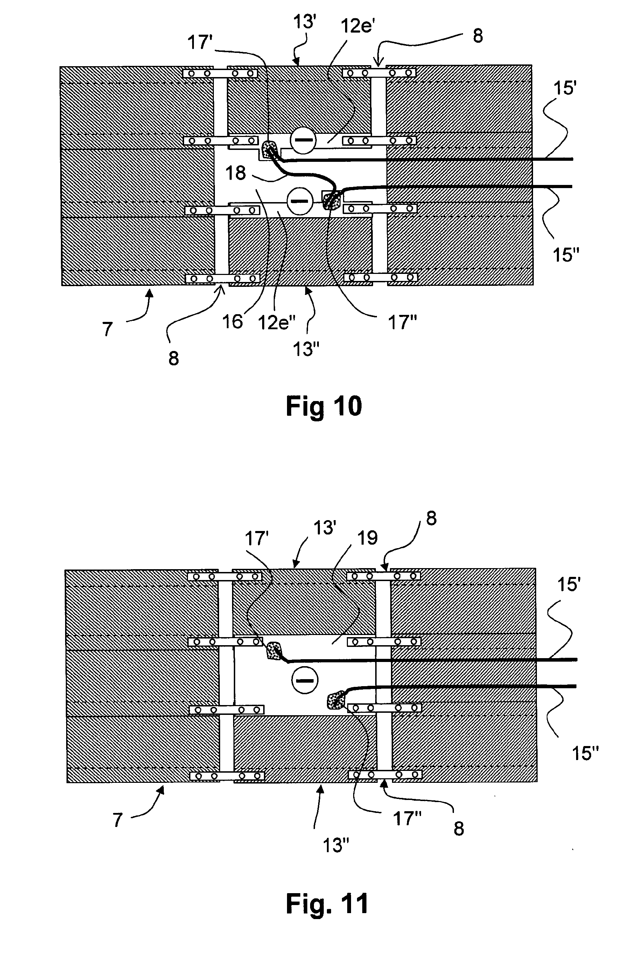

Figure 10 shows a detail of Figure 9 where the ends of the solar cell strings 13' and 13" are positioned in the middle of the solar cell blanket. An open space 16 is created in the solar cell blanket 7 to give room for the fixation 17' and 17" of the wires 15' resp. 15" to the conduction strips 12e' resp. 12e". If the polarity of both string ends is the same (as is shown indeed in figure 9) then it is possible to connect the string ends 13' and 13" together by an additional wire 18 to achieve a redundancy in the electrical transfer wiring

Figure 11 shows a design solution where the said open space 16 is filled with a sheet of conductive material 19 to avoid the loss in stiffness and strength of the solar cell blanket by an open space. This design solution is especially of interest if both string ends 13' resp. 13" have the same polarity and it is allowed to connect electrically the two string ends together. The sheet 19 replaces the conduction strips 12e' and 12e" as shown in figure 10 and is connected to the wires 15' and 15".

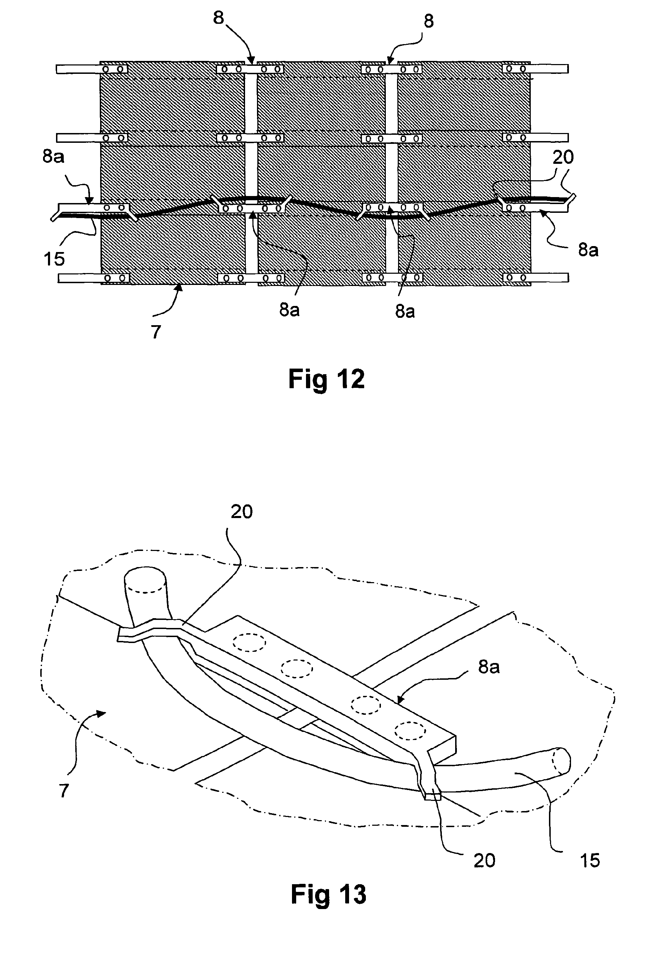

Figure 12 shows another embodiment of the invention where a number of the connection strips 8a are provided with a cable fixation means 20 to mechanically guide and clamp the said electrical wire 15 without the use of bonding materials along the rear side of the solar cell blanket 7.

Figure 13 shows a detail of a shape of the clamps 20 on the connection strip 8a holding cable 15. This is only an example of the various shapes and various positions of the clamps as integral part of said the connection strip 8a.

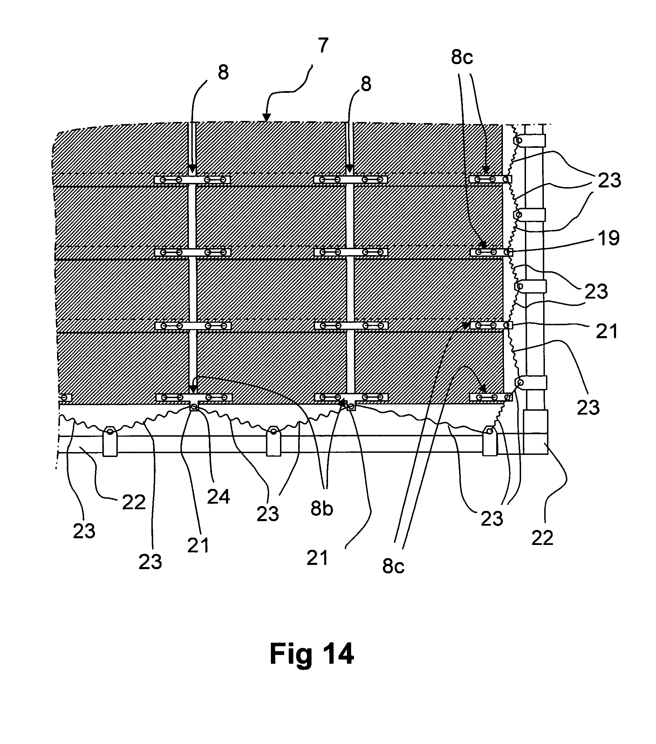

Figure 14 shows another embodiment of the invention, where connection strips 8b resp. 8c are provided with protrusions 21 comprising holes 24 resp.19 to fix the edge of the solar cell blanket 7 to a frame 22 by means of spring elements 23.

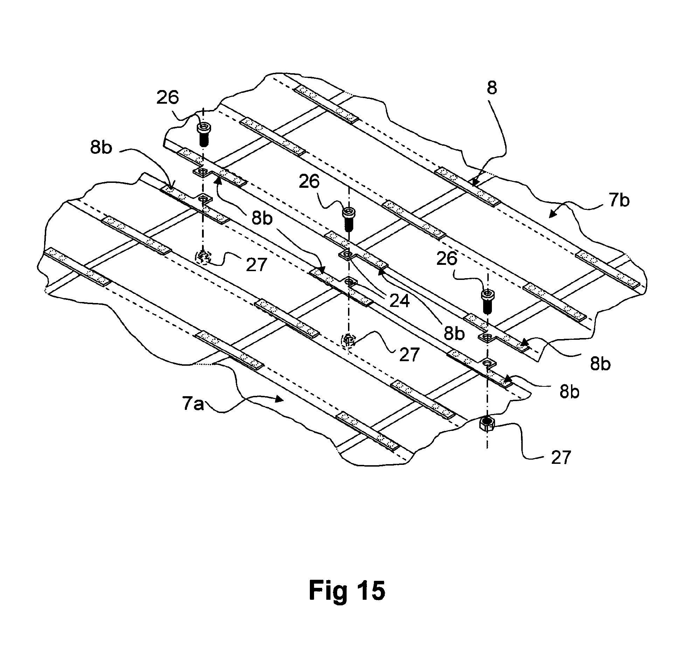

Figure 15 shows how the connection strip 8b can also be used to join the edges of solar cell blankets 7a and 7b to increase the size of the solar blanket. A fixation method using bolts 26 and nuts 27 is shown as an example of the various possible connection methods.

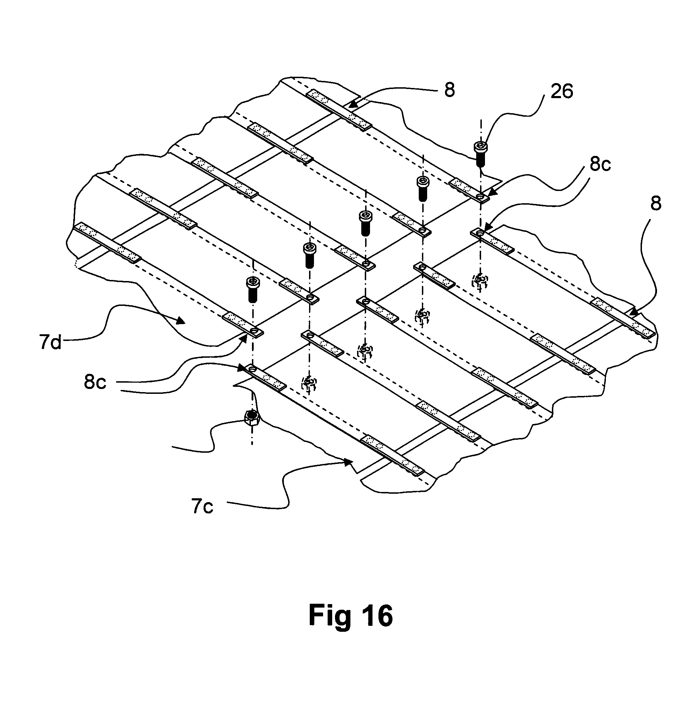

Figure 16 shows a similar connection between solar cell blankets 7c resp. 7d at the other side of the solar cell by joining the connection strips 8c.

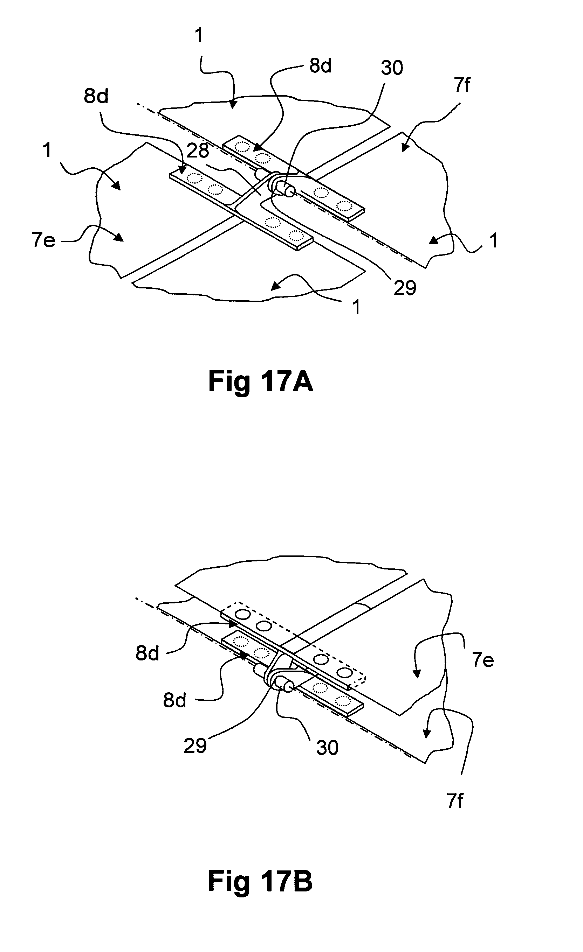

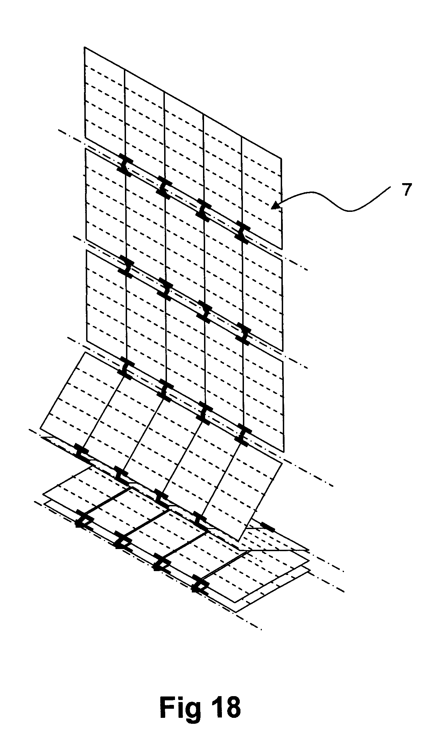

Figures 17A and 17B show another embodiment of the invention, where the solar cells 1 at the edge of a solar cell blanket part are connected with special connection strip 8d. This said connection strip is provided with a lip 28 and hole 29 so that two joined connection strips 8d form a pivotal connection in conjunction with a shaft 30. This particular design can be used to connect solar cell blanket parts 7e and 7f together to form a large solar cell blanket and to facilitate the folding to (or unfolding from) the stowed configuration of the solar cell blanket as shown in figure 18. Figure 17A shows the unfolded configurations of a small detail of the solar cell blanket while figure 17B shows the folded configuration of the same detail

Figure 18 shows in a general schematic of the unfolding of the solar cell blanket 7 using the connection strips 8d at the blanket hinge lines, of which details are shown in

### Figure 17

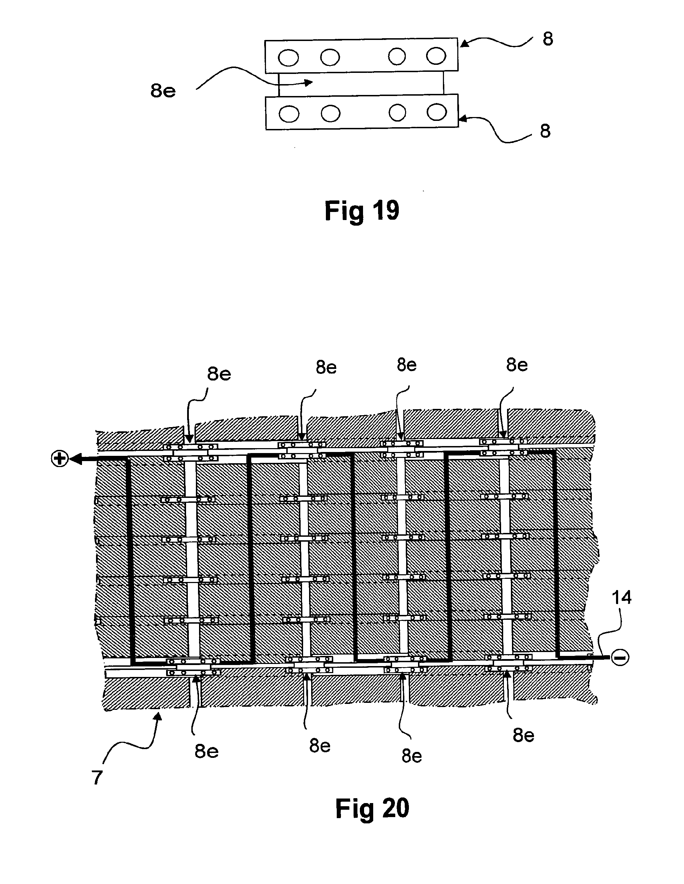

Figure 19 shows another embodiment of the invention where the connection strip 8e has a similar design as two connection strips 8 fixed together with a certain distance from each other.

Figure 20 shows the application of the said connection strips 8e along the width of a solar cell blanket 7. The solar cell overlap in the rows of solar cells will not occur anymore at the location where the solar cells are joined with the connection strip 8e. Effectively the electrical contact is disrupted and the electrical series connection between the solar cells continue sideways similar to what is shown in Figures 8 and 9. The arrow line 14 shows as an example a possible way of series connected solar cells in this part of the solar cell blanket. The solar cell blanket configuration with the said connection strip 8e is useful in keeping the voltage between adjacent solar cells below a certain voltage level.

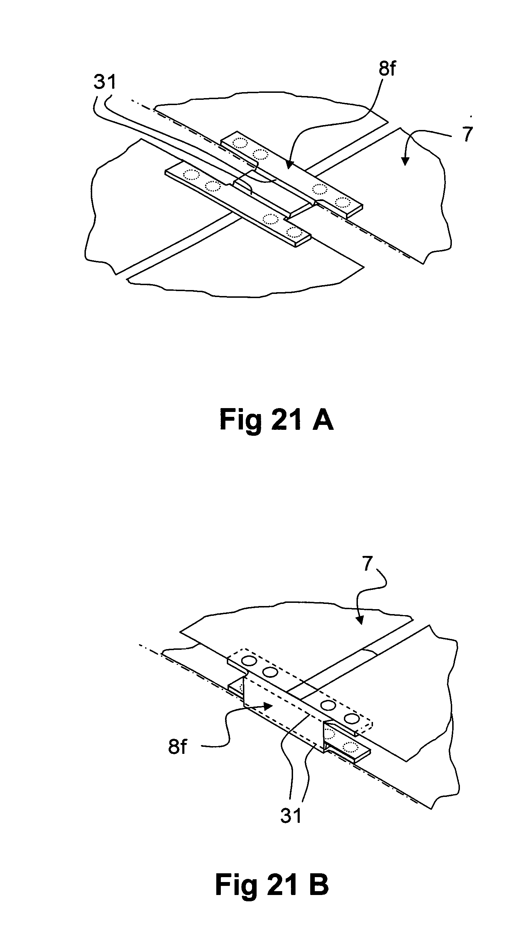

Figure 21A and figure 21B show another embodiment of the invention where connection strip 8f is able to be folded from stowed to deployed and visa versa. The connection strip 8f is a slight modification of connection strip 8e. Figure 21A shows a solar cell blanket 7 connected by a connection strip 8f. This connection strip 8f is provided with a few thinned area's 31 which act as elastic hinges. These thinned area's will give the connection strip 8f a higher flexibility along a line parallel to the internal edge of the blanket. This flexibility will facilitate the folding of the connection strip 8f to the folded condition as shown in Figure 21B. The function of connection strip 8f is then similar to the hinge function of an assembly of two connection strips 8d as shown in Figure 17. The depicted area in figure 21 is a detail of the fold line of the solar cell blanket 7 and can be considered as a detail of the blanket folding principle as shown in figure 18. The groove type shape of the thinned area 31 is just an example of the local thinning of the considered part. Other shapes reducing locally the thickness of the said connection strip are possible having the same effect.

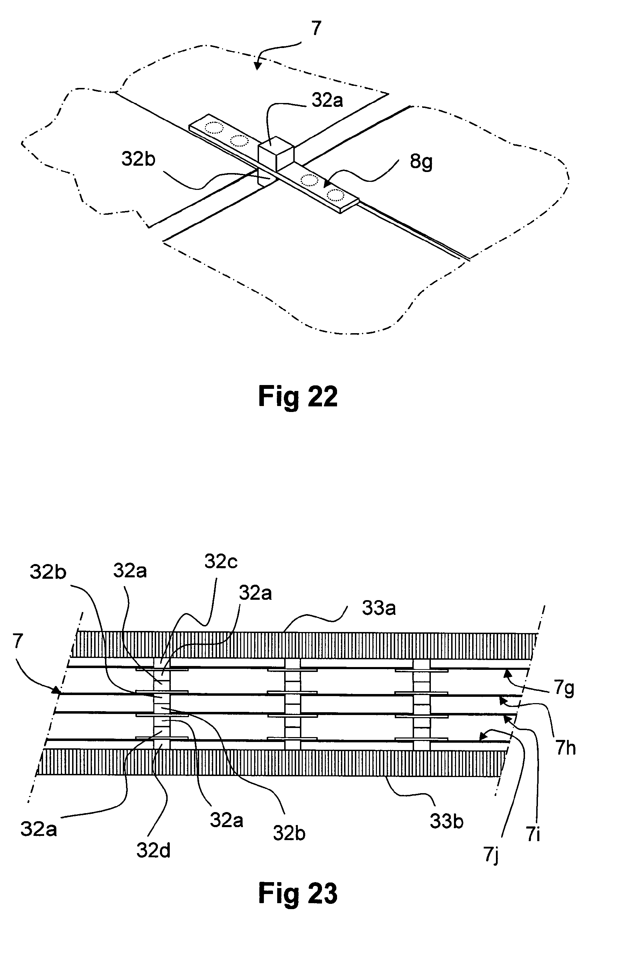

Figure 22 shows another embodiment of the invention, where the connection strips 8g are provided with cushion elements 32a and 32b. These said cushion elements extent above the surface area of the solar cells will in this way protect the solar cell against contact damage in the stowed solar cell blanket condition during the launch of the satellite. These cushion elements 32a resp. 32b will be the contact points when the solar cell blanket is folded together. The shape of the cushion element is drawn as a cubical element as example only. The actual shape may be different. The material of the cushion elements 32a and 32b can differ from each other and may differ from the material of the connection strip. A simple design solution is obtained when the cushion element is made of the same material as the connection strip 8g and made as an integral part. Similar cushion elements can be added to the other presented connection strips resp. 8, 8a, 8b, 8c, 8d, 8e and 8f.

Figure 23 shows a cross-section of the blanket in the launch condition. Here, the blanket 7 is held in a folded condition between two rigid plates 33a and 33b. The solar cell blanket 7 is as example build up out of four solar cell blanket parts 7g, 7h, 7i and 7j which are folded on top of each other. This number of four is only an example. The actual solar cell blanket may consist of a different number of blanket parts/folds. The cross-section shows that the blanket parts are stacked neatly upon each other at the location of the connection strips with the cushion elements 32a resp. 32b. At the side of the pressure plate similar cushion elements 32c resp. 32d are used as the distance between blanket and the pressure plate surface may require a different height of the cushion elements.

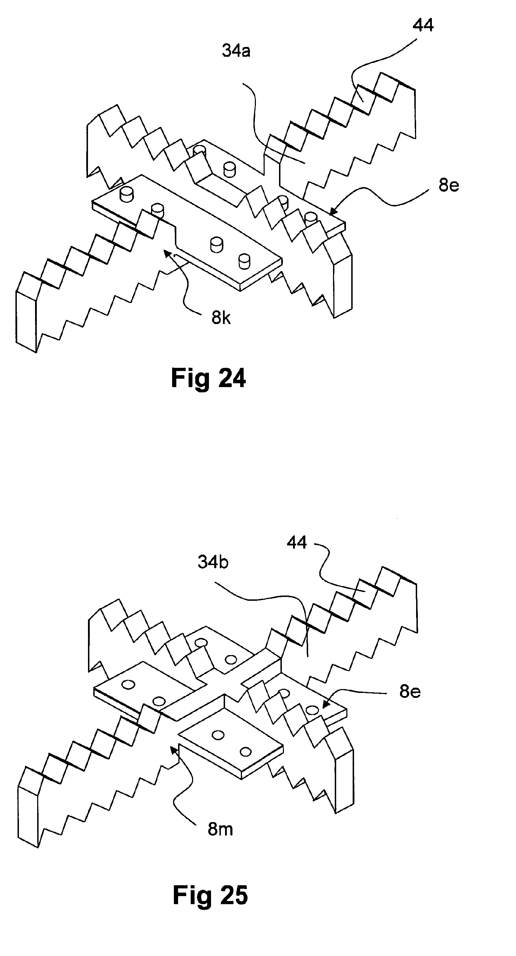

Figure 24 shows another embodiment of the invention. It shows a connection strip 8k that consist of the previously described connection strip 8e combined with a cross arm structure 34a that is able to transfer in-plane shear loads between stowed solar cell blanket layers. The top and bottom surface side of the cross arm structure is provided with grooves. These groves are perpendicular to the local cross arm structure. The cross arm structure 34a with the groves could be added separately to connection strip 8e, but in general it is anticipated that the said cross structure will from an integral part together with connection strip 8e forming thus connection strip 8k. The transfer of in-plane shear forces from the blanket layer to the supporting structure is only possible if the connection strips 8k are stacked on top of similar connection strips located at a similar position in the folded solar cell blanket layers. This is explained in more detail in the next 3 figures.

Figure 25 shows a similar connection strip 8m consisting of a connection strip 8e and a cross arm structure 34b. Connection strip 8m looks the same like connection strips 8k but have some slight differences to allow a proper stacking between connection strip 8m and 8k having these connection strips mounted in a similar relationship with the front or rear side of the solar cells.

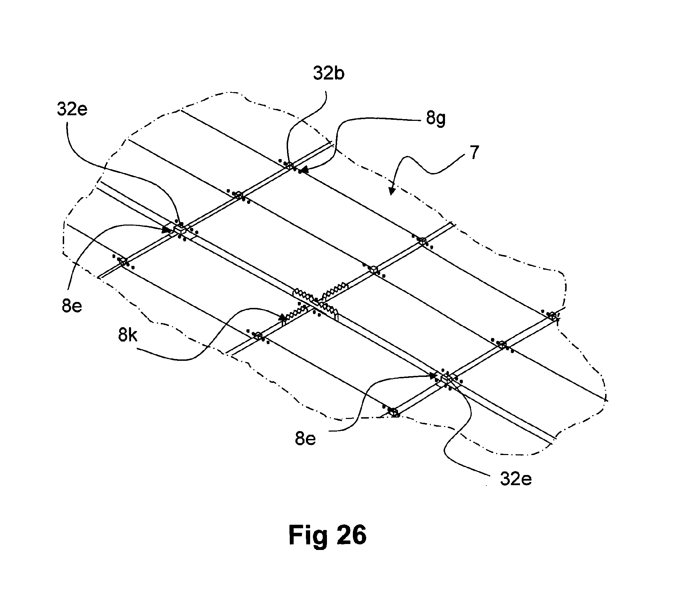

Figure 26 shows as example how connection strip 8k is part of the blanket assembly 7. While connection strip 8k is provided with a cross arm structure for in plane shear forces, the other shown connection strips 8e resp. 8g are all provided with cushion elements 32b resp. 32e. Note, the cushion elements on the solar cell blanket rear side are not shown here.

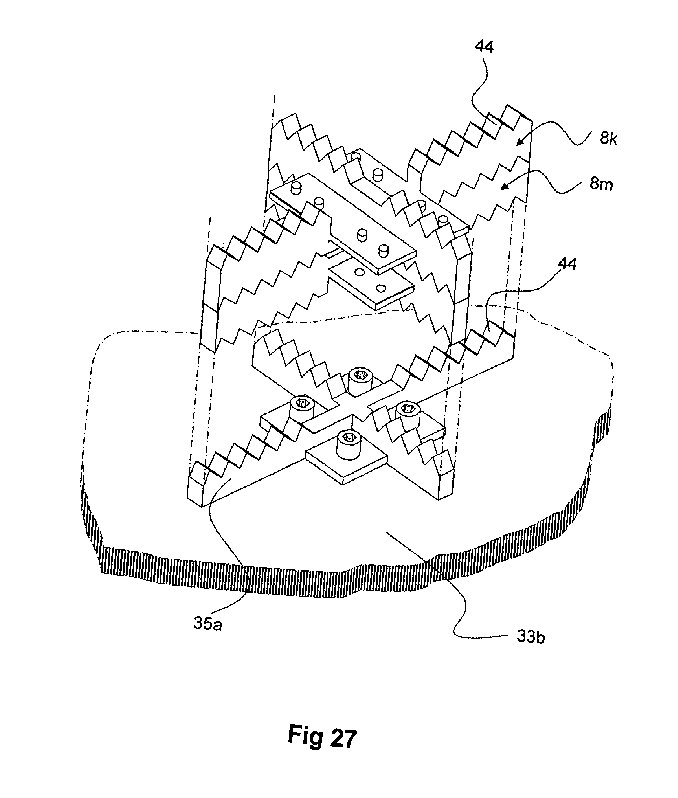

Figure 27 shows in detail the stacking of the connection strips 8k and 8m onto a special shear bracket 35a that is fixed to the pressure plate 33b. A similar bracket will be mounted on the top pressure plate 33a, but is not shown here. Also the solar cells are not shown here for clarity.

### List of references

- 1: solar cell
- 2: solar cell layer of 1
- 3: conductive foil of 1
- 4: grid fingers pattern of 1
- 5: transparant conductive foil of 1
- 6: aperture of 1
- 7: blanket
- 8: electrically isolating connection strip (a, b, ..)
- 9: row (a, b, ...)
- 10: connection element, pin of 10
- 11: closure
- 12: electrical conduction strip (a, b,......)
- 13: solar cell string
- 14: arrow line (fig. 9)
- 15: transfer wire
- 16: open space (fig. 10)
- 17: fixation (fig. 10)
- 18: additional wire (fig. 10)
- 19: hole of 21
- 20: cable fixation means (fig. 13)
- 21: protrusion of 8
- 22: frame (fig. 14)
- 23: spring element (fig. 14)
- 24: hole of 21
- 25: lip of 12
- 26: bolt
- 27: nut
- 28: pivot arm
- 29: hole
- 30: shaft
- 31: elastic hinge
- 32: cushion element (a, b, ...)
- 33: rigid plate (fig. 23)
- 34: cross arm structure (fig. 24)
- 35: shear bracket (fig. 27)
- 36: fingers of 4
- 37: bus bar of 4
- 38: -
- 39: -
- 40: head
- 41: conductive layer of 12
- 42: isolation layer of 12
- 43: folded back end part of 12
- 44: serrations of 32, 34

## Claims

1. Solar cell assembly comprising a plurality of film solar cells (1) which are arranged in a row (9a, 9b, ....), in which row the front edge of a preceding solar cell (1) overlaps the back edge of an adjacent subsequent solar cell (1) and the overlapping corners of said overlapping edges are connected to each other, **characterised in that** at least one electrically isolating connection element (10) is provided which protrudes through two overlapping corners.

2. Assembly according to claim 1, wherein each overlapping corner of a solar cell (1) has at least one aperture (6), each aperture of a solar cell (1) being in register with an aperture (6) of the adjacent solar cell (1) and said registered apertures (6) each accommodating a connection element (10).

3. Assembly according to claim 2, wherein each solar cell (1) comprises a laminate of a conductive foil (3), a solar cell layer (2), a transparent conductive coating (5) and a conductive grid (4), each aperture (6) extending through a part of the conductive foil (3) and a part of the solar cell layer (2), which parts protrude with respect to the transparent conductive coating (5) and the conductive grid (4).

4. Assembly according to claim 3, wherein the transparent conductive coating (3) and the conductive grid (4) are recessed with respect to the part of the conducting foil (3) and the part of the conductive grid (4) which are apertured.

5. Assembly according to any of the preceding claims 2, wherein the connection elements each comprise at least one pin (10) which protrudes through a pair of registered apertures (6), said pin (10) having at one end a head (40), as well as a closure (11) fitted on the pin (10), between which head (40) and closure (11) the corners of the solar cells (1) are enclosed.

6. Assembly according to claim 5, wherein the connection elements each comprise two pins (10) which have a common head (40).

7. Assembly according to claim 5 or 6, wherein the pins (10) are connected to the closure (11) through a snap fit.

8. Assembly according to claim 6 or 7, wherein the head (40) has a cable fixation means (20) for holding a transfer wire (15).

9. Assembly according to any of claims 3-8, wherein the closures (11) have a resilient character, e.g. a wave form, for providing a compressive preload in the direction perpendicular with respect to the facing sides of the overlapping edges.

10. Assembly according to any of the preceding claims, wherein the overlapping edges of adjacent solar cells (1) comprise facing electrically conduction layers which are electrically connected.

11. Assembly according to claim 10, wherein an electrically conducting strip (12) is accommodated between each pair of overlapping edges.

12. Assembly according to claim 11, wherein at least one of the connecting elements (10) protrude through the electrically conducting strip (12).

13. Assembly according to claim 10, 11 or 12, wherein the electrically conducting strip (12) provides resiliency in the direction perpendicular with respect to the facing sides of the overlapping edges.

14. Assembly according to claim 13, wherein the electrically conducting strip (11a) has a wave form.

15. Assembly according to claim 13, wherein the electrically conducting strip (12b) at its opposite ends has end parts (43) which are folded back, the connection elements (10) protruding through both the electrically conducting strip (12b) and the folded back end parts (43).

16. Assembly according to any of claims 11-15, wherein the conducting strip (12f) comprises a laminate with an electrically isolating layer (42) and an electrically conducting layer (41), at least one lip (25) being provided at the opposite ends of the strip (12f), said lips (25) being bent over so as to overlap the remainder of the conducting strip (12f) in such a way that the electrically conducting layer (41) of the lip (25) and of the remainder of the conducting strip (12f) face away from each other, the lip (25) being in contact with an electrically conducting surface of one of the overlapping edges and the remainder of the conducting strip (12f) being in contact with the other of the overlapping edges.

17. Assembly according to claim 16, wherein the lip (25) is at a longitudinal edge of the remainder of the strip.

18. Assembly according to claim 16 or 17, wherein the lip (25) is next to the apertures.

19. Solar cell blanket (7), comprising a plurality of solar cell assemblies according to any of the preceding claims, said assemblies each comprising a plurality of film solar cells (1) which are arranged in a row (9a, 9b, ....), in which row the front edge of a preceding solar cell (1) overlaps the back edge of an adjacent subsequent solar cell (1) and the overlapping corners of said overlapping edges are connected to each other, the rows (9a, 9b, ....) of solar cells of said assemblies being positioned next to each other in such a way that the longitudinal sides of two neighbouring rows (9a, 9b,.......) face each other, **characterised in that** a connection element (10) at a corner of a cell (1) in one of the rows (9a, 9b, ....) is connected to a neighbouring connection element (10) at a corner of a cell (1) in a neighbouring row (9a, 9b, ...).

20. Blanket (7) according to claim 19, wherein the neighbouring connection elements (10) are interconnected through an electrically isolating connection strip (8).

21. Blanket (7) according to claim 20, wherein a connection strip (8b, 8c) at the back end and/or the front end of the rows has a protrusion (21) for suspending to a frame (22).

22. Blanket (7) according to claim 19 or 20, wherein at least one electrically conducting strip (12c, 12d) is provided which extends over at least two rows (9c, 9f).

23. Blanket (7) according to claim 22, wherein the electrically conducting strip (12c) which extends over at least two rows (9c, 9d) provides a parallel connection between said rows (9c, 9d) (fig. 7).

24. Blanket (7) according to claim 22, wherein the electrically conducting strip (12d) which extends over at least two rows (9e, 9f) provides a series connection between said rows (9e, 9f) (fig. 8).

25. Set of at least two blankets (7) according to any of claims 20-24, wherein a connection strip (8b, 8c, 8d, 8e, 8f) of one blanket (7) is connected to a connection strip (8b, 8c, 8d, 8e, 8f) of another blanket (7) (fig. 15-18, 21-26).

26. Set according to claim 25, wherein the connection is a pin connection, e.g. a bolt connection (26, 27).

27. Set according to claim 25, wherein the connection is a hinge connection (28-31).

28. Set according to claim 27, wherein in one blanket (7) a connection strip (8) which is positioned between four neighbouring corners has a cushion element (32) for abutting against a correspondingly positioned cushion element (32) of the other blanket (7) when said blankets are folded over onto each other.

29. Set according to claim 28, wherein a cushion element (32) of one of the blankets (7) has serrations (44) which engage similar serrations (44) on the cushion element (32) of the other blanket (7) when said blankets (7) are folded over onto each other, for preventing relative motions of said blankets (7) parallel to each other.

30. Set according to any of claims 28 or 29, wherein the connection strip has two opposite cushion elements (32) which face away from each other.

31. Set according to claim 29, wherein the serrations (44) extend in the lengthwise direction of the rows (7) and/or in the breadthwise direction of the rows (7).
